# EUROPÄISCHE PATENTSCHRIFT

(11) **EP 3 063 797 B1**
(45) Veröffentlichungstag und Bekanntmachung des Hinweises auf die Patenterteilung: **18.04.2018**
(21) Anmeldenummer: 14783586.2
(22) Anmeldetag: 06.10.2014
(51) Int. Cl.: H01L 35/32, H01L 35/30, H01L 23/31, H05K 1/02, H05K 1/18

(54) **ELEKTRISCHE SCHALTUNG UND VERFAHREN ZUR HERSTELLUNG EINER ELEKTRISCHEN SCHALTUNG**
ELECTRICAL CIRCUIT AND METHOD FOR PRODUCING AN ELECTRICAL CIRCUIT
CIRCUIT ÉLECTRIQUE ET PROCÉDÉ PERMETTANT DE PRODUIRE UN CIRCUIT ÉLECTRIQUE

(30) Priorität: 31.10.2013 DE 102013222163
(43) Veröffentlichungstag der Anmeldung: 07.09.2016
(73) Patentinhaber: Robert Bosch GmbH, 70442 Stuttgart (DE)
(72) Erfinder: PIRK, Tjalf, 70195 Stuttgart (DE); EHRENPFORDT, Ricardo, 70825 Korntal-Muenchingen (DE); ANTE, Frederik, 70197 Stuttgart (DE); KENNTNER, Johannes, 70825 Korntal-Muenchingen (DE)
(86) Internationale Anmeldenummer: PCT/EP2014/071347
(87) Internationale Veröffentlichungsnummer: WO 2015/062818

(56) Entgegenhaltungen:
- WO-A2-2013/107637
- DE-A1-102005 043 771
- JP-A- 2008 061 375
- US-A1- 2007 125 413
- US-A1- 2012 201 008
- US-A1- 2012 312 345

## Beschreibung

### Stand der Technik

Die vorliegende Erfindung bezieht sich auf eine elektrische Schaltung sowie auf ein Verfahren zur Herstellung einer elektrischen Schaltung.

Um elektrische Energie aus einem Wärmestrom gewinnen zu können, bedarf es einer Zuleitung und einer Ableitung des Wärmestroms zu einem thermoelektrischen Generator.

Die DE 101 25058A1 beschreibt einen thermisch speisbaren Sender und ein Sensorsystem. Die Druckschrift US 2012/312345 A1 zeigt ein System und ein Verfahren zum thermischen Schutz eines Elektronikmoduls eines Energie-Harvesters.

### Offenbarung der Erfindung

Vor diesem Hintergrund wird mit dem hier vorgestellten Ansatz eine elektrische Schaltung sowie ein Verfahren zur Herstellung einer elektrischen Schaltung gemäß dem Hauptanspruch vorgestellt. Vorteilhafte Ausgestaltungen ergeben sich aus den jeweiligen Unteransprüchen und der nachfolgenden Beschreibung.

Eine elektrische Schaltung benötigt zum Schutz vor Umwelteinflüssen ein Gehäuse. In dem Gehäuse kann eine Funktionalität zum Leiten eines Wärmestroms zu oder von einem thermoelektrischen Generator der Schaltung integriert werden. Dadurch kann auf einen zusätzlichen Wärmetauscher für den thermoelektrischen Generator verzichtet werden.

Durch den hier vorgestellten Ansatz kann eine autarke elektrische Schaltung kostengünstig und kleinbauend bereitgestellt werden.

Es wird eine elektrische Schaltung mit folgenden Merkmalen vorgestellt:
einem Bauelement, insbesondere einem Sensorelement zum Erfassen einer Messgröße, wobei das Bauelement mit einer Elementseite eines Trägerelements der Schaltung mechanisch verbunden ist;
einem thermoelektrischen Generator, der elektrisch mit dem Bauelement verbunden ist und ebenfalls mit dem Trägerelement mechanisch verbunden ist, wobei der thermoelektrische Generator dazu ausgebildet ist, das Bauelement unter Verwendung eines, den thermoelektrischen Generator (und das Trägerelement) durchströmenden Wärmestroms mit elektrischer Energie zu versorgen; und
einem Gehäuse, das auf der Elementseite des Trägerelements angeordnet ist und das Bauelement sowie den thermoelektrischen Generator zumindest teilweise bedeckt, wobei das Gehäuse dazu ausgebildet ist, den Wärmestrom zu dem thermoelektrischen Generator zu leiten.

Unter einer elektrischen Schaltung kann insbesondere ein autarkes Sensorsystem verstanden werden. Die elektrische Schaltung kann auch als elektronische Schaltung verstanden werden. Ein Bauelement kann ein mikroelektrisches Bauelement, insbesondere ein mikroelektromechanisches Bauelement sein. Ein Sensorelement kann ein mikroelektromechanisches Sensorelement sein. Ein Trägerelement kann ein Trägersubstrat sein. Beispielsweise kann das Trägerelement eine Leiterplatte sein. Eine Elementseite kann eine Oberseite des Trägerelements sein. Das Bauelement kann auf das Trägerelement aufgeklebt oder aufgelötet sein. Ein thermoelektrischer Generator kann zwei unterschiedliche Materialien aufweisen, zwischen denen durch einen Temperaturunterschied zwei unterschiedliche elektrische Potenziale entstehen. Wenn die Materialien an einer Seite miteinander verbunden werden, kann zwischen den anderen Seiten eine elektrische Spannung abgegriffen werden. Wenn ein elektrischer Strom abgegriffen wird, wird der Temperaturunterschied verringert, wodurch ein Wärmestrom entsteht. Der Wärmestrom fließt dabei von einer höheren Temperatur zu der niedrigeren Temperatur.

Das Gehäuse ist dazu ausgebildet, einen Fluidstrom eines Fluids zu dem thermoelektrischen Generator zu leiten, wobei das Fluid als Trägermedium für den Wärmestrom verwendet wird. Ein Fluidstrom kann beispielsweise ein Luftstrom sein. Das Gehäuse kann Leiteinrichtungen für den Fluidstrom, wie zumindest einen Kanal aufweisen. Das Gehäuse kann Öffnungen für den Fluidstrom aufweisen. Der Fluidstrom kann den Wärmestrom durch Konvektion übertragen.
Das Gehäuse kann eine erste, direkt auf dem Trägerelement angeordnete erste Schicht und zumindest eine auf der ersten Schicht angeordnete zweite Schicht aufweisen. Die erste Schicht kann einen Kanal zum Leiten des Fluidstroms aufweisen. Durch einen Kanal kann der Fluidstrom zielgerichtet zu dem thermoelektrischen Generator geleitet werden.
Das Gehäuse kann ein wärmeleitendes Material aufweisen und dazu ausgebildet sein, den Wärmestrom über Wärmeleitung zu dem thermoelektrischen Generator zu leiten. Ein wärmeleitendes Material kann ein Metall sein. Durch das wärmeleitende Material kann das Gehäuse eine stark vergrößerte Wärmeübergangsfläche für den Wärmestrom bereitstellen.
Der thermoelektrische Generator kann zumindest teilweise in dem Trägerelement versenkt angeordnet sein. Dadurch kann eine Bauhöhe der Schaltung verringert werden.
Das Gehäuse kann einen direkten, wärmeleitenden Kontakt zu dem thermoelektrischen Generator aufweisen. Über einen direkten Kontakt kann eine große Wärmestromdichte übertragen und/oder geleitet werden.
Zwischen dem Gehäuse und dem thermoelektrischen Generator kann ein wärmeleitendes Wärmeübertragungselement angeordnet sein, das thermisch mit dem Gehäuse und dem thermoelektrischen Generator gekoppelt ist. Ein Wärmeübertragungselement kann einen Abstand zwischen dem Gehäuse und dem thermoelektrischen Generator überbrücken.

Das Bauelement kann ein Massenflusssensor sein. Ein Massenflusssensor kann den Fluidstrom quantifizieren.

Zwischen dem Bauelement und dem Trägerelement kann eine Zwischenschicht angeordnet sein. Die Zwischenschicht kann das Bauelement von dem Trägerelement beabstanden.

Das Trägerelement kann zumindest eine wärmeleitende Durchkontaktierung zum Leiten des Wärmestroms durch das Trägerelement aufweisen. Die Durchkontaktierung kann thermisch mit dem thermoelektrischen Generator gekoppelt sein. Durch die Durchkontaktierung kann das Trägerelement als Trennung zwischen einer hohen Temperatur und einer niedrigen Temperatur am thermoelektrischen Generator dienen. Die Durchkontaktierung kann den Wärmestrom besonders gut transportieren.

Das Trägerelement kann zumindest einen Durchbruch zum Leiten des Wärmestroms durch das Trägerelement aufweisen. Der Durchbruch kann im Bereich einer Kontaktfläche zwischen dem thermoelektrischen Generator und dem Trägerelement angeordnet sein. In dem Durchbruch kann ein weiterer Fluidstrom den Transport des Wärmestroms übernehmen.

Die elektrische Schaltung kann zumindest ein weiteres Bauelement aufweisen, das elektrisch mit dem thermoelektrischen Generator verbunden ist, wobei das weitere Bauelement dazu ausgebildet ist, von dem thermoelektrischen Generator mit elektrischer Energie versorgt zu werden. Das weitere Bauelement kann ein weiteres Sensorelement sein. Das weitere Bauelement kann ein integrierter Schaltkreis sein. Durch das weitere Bauelement kann die Schaltung weitere Aufgaben erfüllen.

Das "Internet der Dinge (Internet of things, IoT) wird als eine der wichtigsten zukünftigen Entwicklung in der Informationstechnologie bezeichnet. Unter dem IoT wird verstanden, dass nicht nur Menschen Zugang zum Internet haben und über dieses vernetzt sind, sondern dass auch Geräte über das Internet miteinander vernetzt sind. Ein Bereich des "Internet der Dinge" zielt Richtung Produktions- und Hausautomatisierung, z. B. zur Temperaturmessung. Mit Sensoren für Smartphones (Gyroskope, Beschleunigungssensoren, Drucksensoren, Mikrofone) können solche Sensoren kostengünstig hergestellt werden, die gleichzeitig die benötigte elektrische Energie mit sogenannten "Energy Harvestern" aus der Umwelt gewinnen. Beispielsweise kann mit einem thermoelektrischen Generator (TEG) Energie aus einer Temperaturdifferenz, z. B. an einer Heizung gewonnen werden.

Die Effizienz eines TEGs ist umso höher, je größer die Temperaturdifferenz zwischen den beiden aktiven Schichten des TEGs ist, wodurch der Seebeck-Effekt wirkt. Da die Wärmeleitfähigkeit des TEGs einen endlichen Wert aufweist, würde sich ohne externen Wärmefluss nach einer bestimmten Zeit zwischen den beiden aktiven Schichten die gleiche Temperatur einstellen. In diesem Fall wäre es nicht mehr möglich, aus dem TEG Energie zu gewinnen. Deshalb kann die kühlere Seite des TEG mit einem Kühlkörper, typischerweise aus Metall thermisch verbunden werden. Hierdurch kann die Wärme aus dem Wärmestrom durch die aktive Schicht direkt an die Umgebung abgegeben werden, sodass eine ausreichend große Temperaturdifferenz im TEG selbst aufrechterhalten wird.

Bei dem hier vorgestellten Ansatz wird der Kühlkörper in das Gehäuse integriert. Dadurch werden eine kleinbauende Integration in das Sensorsystem und reduzierte Kosten durch den Entfall zusätzlichen Aufwands für die Fertigung und das Anbringen des Kühlkörpers möglich.

Beispielsweise kann das Sensorelement mit Luft durchströmt werden, um die aufgenommene Wärme wieder abzugeben.

Der hier vorgestellte Ansatz wird nachstehend anhand der beigefügten Zeichnungen beispielhaft näher erläutert. Es zeigen:
- Fig. 1: eine Schnittdarstellung einer elektrischen Schaltung gemäß einem Ausführungsbeispiel der vorliegenden Erfindung;
- Fig. 2: eine Draufsicht auf eine elektrische Schaltung gemäß einem Ausführungsbeispiel der vorliegenden Erfindung;
- Fig. 3: eine Schnittdarstellung einer elektrischen Schaltung mit thermischen Durchkontaktierungen gemäß einem Ausführungsbeispiel der vorliegenden Erfindung;
- Fig. 4: eine Draufsicht auf eine elektrische Schaltung mit thermischen Durchkontaktierungen gemäß einem Ausführungsbeispiel der vorliegenden Erfindung;
- Fig. 5: eine Schnittdarstellung einer elektrischen Schaltung mit einem Wärmeübertragungselement gemäß einem Ausführungsbeispiel der vorliegenden Erfindung;
- Fig. 6: eine Draufsicht auf eine elektrische Schaltung mit einem Wärmeübertragungselement gemäß einem Ausführungsbeispiel der vorliegenden Erfindung;
- Fig. 7: eine Schnittdarstellung einer elektrischen Schaltung mit teilweise versenktem thermoelektrischen Generator gemäß einem Ausführungsbeispiel der vorliegenden Erfindung;
- Fig. 8: eine Schnittdarstellung einer elektrischen Schaltung mit versenktem thermoelektrischen Generator gemäß einem Ausführungsbeispiel der vorliegenden Erfindung;
- Fig. 9: eine Schnittdarstellung einer elektrischen Schaltung mit erweitertem Deckel gemäß einem Ausführungsbeispiel der vorliegenden Erfindung;
- Fig. 10: eine Draufsicht auf eine elektrische Schaltung mit erweitertem Deckel gemäß einem Ausführungsbeispiel der vorliegenden Erfindung;
- Fig. 11: eine Schnittdarstellung einer elektrischen Schaltung mit eingebettetem thermoelektrischen Generator gemäß einem Ausführungsbeispiel der vorliegenden Erfindung;
- Fig. 12: eine Draufsicht auf eine elektrische Schaltung mit einem Wärmeübertragungselement gemäß einem Ausführungsbeispiel der vorliegenden Erfindung;
- Fig. 13: eine Schnittdarstellung einer elektrischen Schaltung mit einem Massenflusssensor gemäß einem Ausführungsbeispiel der vorliegenden Erfindung;
- Fig. 14: eine Draufsicht auf eine elektrische Schaltung mit einem Massenflusssensor gemäß einem Ausführungsbeispiel der vorliegenden Erfindung;
- Fig. 15: eine Schnittdarstellung einer elektrischen Schaltung mit einem Gehäuse mit Kanal gemäß einem Ausführungsbeispiel der vorliegenden Erfindung;
- Fig. 16: eine Schnittdarstellung einer elektrischen Schaltung mit abgewinkeltem Massenfluss gemäß einem Ausführungsbeispiel der vorliegenden Erfindung;
- Fig. 17: eine Schnittdarstellung einer elektrischen Schaltung mit einem Gehäuse mit Kanal und abgewinkeltem Massenfluss gemäß einem Ausführungsbeispiel der vorliegenden Erfindung;
- Fig. 18: eine Schnittdarstellung einer elektrischen Schaltung mit aufgesetztem thermoelektrischen Generator gemäß einem Ausführungsbeispiel der vorliegenden Erfindung;
- Fig. 19: eine Schnittdarstellung einer elektrischen Schaltung mit einem erhöhten Massenflusssensor gemäß einem Ausführungsbeispiel der vorliegenden Erfindung;
- Fig. 20: eine Schnittdarstellung einer elektrischen Schaltung mit mehreren Bauelementen gemäß einem Ausführungsbeispiel der vorliegenden Erfindung;
- Fig. 21: eine Schnittdarstellung einer elektrischen Schaltung mit einem Kanal zwischen gestapelten Leiterplatten gemäß einem Ausführungsbeispiel der vorliegenden Erfindung; und
- Fig. 22: ein Ablaufdiagramm eines Verfahrens zum Herstellen einer elektrischen Schaltung gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

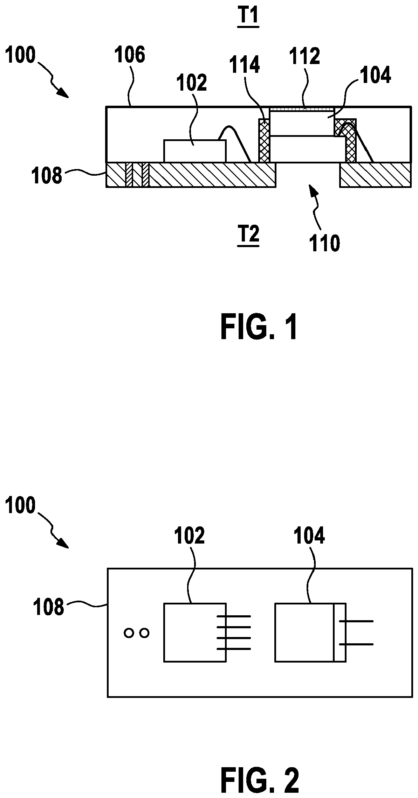

Fig. 1 zeigt eine Schnittdarstellung einer Seitenansicht einer elektrischen Schaltung 100 gemäß einem Ausführungsbeispiel der vorliegenden Erfindung. Die elektrische Schaltung weist ein Bauelement 102, einen thermoelektrischen Generator 104 und ein Gehäuse 106 auf. Das Bauelement 102 ist mit einer ersten Seite eines Trägerelements 108 der Schaltung 100 mechanisch verbunden. Die erste Seite kann als Elementseite bezeichnet werden. Der thermoelektrische Generator 104 ist elektrisch mit dem Bauelement 102 verbunden. Der thermoelektrische Generator 104 ist ebenfalls mit dem Trägerelement 108 mechanisch verbunden. Der thermoelektrische Generator 104 ist dazu ausgebildet, das Bauelement 102 unter Verwendung eines, den thermoelektrischen Generator 104 durchströmenden Wärmestroms mit elektrischer Energie zu versorgen. Das Gehäuse ist auf der Elementseite des Trägerelements 108 angeordnet und bedeckt das Bauelement 102 sowie den thermoelektrischen Generator 104. Das Gehäuse 106 ist dazu ausgebildet, den Wärmestrom zu dem thermoelektrischen Generator 104 zu leiten. Der Wärmestrom durch den thermoelektrischen Generator 104 fließt, wenn an einer ersten Kontaktfläche des thermoelektrischen Generators 104 eine erste Temperatur T1 anliegt und gleichzeitig an einer gegenüberliegenden zweiten Kontaktfläche des thermoelektrischen Generators 104 eine zweite Temperatur T2 anliegt und zwischen der ersten Temperatur T1 und der zweiten Temperatur T2 eine Temperaturdifferenz ΔT besteht. Der Wärmestrom fließt dann von der höheren Temperatur zu der niedrigeren Temperatur.

In einem Ausführungsbeispiel weist das Trägerelement 108 Leiterbahnen zum Leiten von elektrischem Strom auf. Dann kann das Trägerelement 108 als Leiterplatte 108 bezeichnet werden. Das Bauelement 102 und/oder der thermoelektrische Generator 104 sind über Drahtbonds mit den Leiterbahnen der Leiterplatte 108 verbunden. Sowohl das Bauelement 102, als auch der thermoelektrische Generator 104 können direkt auf die Leiterplatte 108 gelötet sein.

In einem Ausführungsbeispiel weist das Trägerelement 108 elektrische Durchkontaktierungen bzw. Elektrische Vias von der Elementseite zu einer gegenüberliegenden Rückseite auf.

In einem Ausführungsbeispiel ist das Bauelement 102 ein Sensorelement 102 zum Erfassen einer Messgröße. Beispielsweise ist das Bauelement 102 ein MEMS-Sensor 102 mit Drahtbonds (mikroelektromechanischer Sensor).

In einem Ausführungsbeispiel ist der thermoelektrische Generator 104 dazu ausgebildet, das Bauelement 102 unter Verwendung eines, den thermoelektrischen Generator 104 und das Trägerelement 108 durchströmenden Wärmestroms mit elektrischer Energie zu versorgen. Das Trägerelement 108 ist dazu ausgebildet, die erste Temperatur T1 von der zweiten Temperatur T2 lokal thermisch zu isolieren, um den Wärmestrom durch den thermoelektrischen Generator 104 zu leiten.

In einem Ausführungsbeispiel weist das Trägerelement 108 zumindest einen Durchbruch 110 zum Leiten des Wärmestroms durch das Trägerelement 108 auf, wobei der Durchbruch 110 im Bereich einer Kontaktfläche zwischen dem thermoelektrischen Generator 104 und dem Trägerelement 108 angeordnet ist. Durch den Durchbruch kann ein Fluidstrom, wie beispielsweise ein Luftstrom zum Transport des Wärmestroms direkt an die Kontaktfläche des thermoelektrischen Generators 104 herangeführt werden.

In einem Ausführungsbeispiel weist das Gehäuse 106 ein wärmeleitendes Material 112 auf und ist dazu ausgebildet, den Wärmestrom über Wärmeleitung zu dem thermoelektrischen Generator 104 zu leiten. Beispielsweise ist das Gehäuse 106 aus Metall bzw. ein Metalldeckel und liegt wärmeleitend an dem thermoelektrischen Generator 104 an. Durch das wärmeleitende Material 112 weist das Gehäuse 106 einen direkten, wärmeleitenden Kontakt zu dem thermoelektrischen Generator 104 auf.

In einem Ausführungsbeispiel ist zwischen dem Gehäuse 106 und dem thermoelektrischen Generator 104 ein wärmeleitendes Material 112 angeordnet. Beispielsweise ist das wärmeleitende Material 112 eine Wärmeleitpaste 112 oder ein Gel als Toleranzausgleich. Das wärmeleitende Material 112 ist dazu ausgebildet, eine Abstandstoleranz zwischen dem Gehäuse 106 und dem thermoelektrischen Generator 104 auszugleichen. Das wärmeleitende Material 112 bildet eine Temperaturbrücke zwischen dem Gehäuse 106 und dem thermoelektrischen Generator 104 aus.

In einem Ausführungsbeispiel ist der thermoelektrische Generator 104 auf einer Oberfläche des Trägerelements 108 aufliegend angeordnet. Der thermoelektrische Generator 104 steht also über das Trägerelement 108 über. Zum Verhindern eines thermischen Kurzschlusses zwischen der ersten Kontaktfläche und der zweiten Kontaktfläche ist der thermoelektrische Generator 104 mit einem thermisch isolierenden Material 114 isoliert. Das thermisch isolierende Material 114 umschließt den thermoelektrischen Generator 104 an seinen Seitenflächen und lässt die Kontaktflächen für den Wärmestrom frei zugänglich.

In dem hier beschriebenen Ausführungsbeispiel ist der thermoelektrische Generator (TEG) 104 mit der Seite T2 nur mit der Umgebungsluft in Kontakt. Für den Fall, dass auf der Seite T2 beispielsweise ein Heizkörper angeordnet ist, so entsteht zwischen Heizkörper und der Fläche T2 des TEGs 104 ein (thermisch isolierender) Luftraum. Für eine verbesserte Wärmeleitfähigkeit kann diese Kavität mit Wärmeleitpaste aufgefüllt werden.

In einem Ausführungsbeispiel ist der Durchbruch 110 durch das Trägerelement 108 mit dem wärmeleitenden Material gefüllt. Durch die Füllung kann der Wärmestrom durch direkte Wärmeleitung auf einen Festkörper übertragen werden, der in Kontakt mit dem Material steht.

Mit anderen Worten zeigt Fig. 1 die thermische Anbindung eines Sensordeckels 106 an ein thermoelektrisches Generatormodul 104.

Der hier vorgestellte Ansatz beschreibt einen kleinbauenden und kostengünstigen thermoelektrischen Generator (TEG) 104, der in ein autonomes Sensorsystem 100 mit einer Grundfläche von einigen cm2 integriert ist. Der TEG 104 verwendet dabei den metallischen Deckel 106 des Sensorsystems 100 als integrierten Kühlkörper.

Durch den hier vorgestellten Ansatz entstehen keine zusätzlichen Kosten für einen Kühlkörper, da der als Kühlkörper verwendete metallische Deckel 106 zum Schutz der Sensoren 102 bereits vorhanden ist. Die thermische Kontaktierung des Deckels 106 erfolgt dabei mit Standardtechnologien der Leiterplattentechnik, wie Kupferbahnen und/oder thermische Vias und/oder mit Standardtechniken des Elektronik-Verpackens, wie Dispensen und/oder Siebdruck. Die Verwendung eines Deckels mit einer dreidimensionalen Oberflächenstruktur 106 kann die Kühl-Oberfläche erhöhen.

Die hier gezeigten Ausführungsbeispiele weisen alle zumindest einen thermoelektrischen Generator (TEG) 104 mit zwei Temperaturbereichen T1, T2, einen oder mehrere verschiedene mikroelektromechanische (MEMS) Sensoren 102, eine Leiterplatte 108 und einen metallischen Deckel 106 auf. Dabei ist zur Vereinfachung jeweils nur ein Sensor 102 dargestellt.

Der TEG 104 benötigt zur Erzeugung einer elektrischen Spannung eine Temperaturdifferenz zwischen einer ersten Temperatur T1 und einer zweiten Temperatur T2. Die warme und kalte Temperaturseite sind dabei austauschbar. Zur Verbesserung des Wirkungsgrads des TEG 104 kann der TEG 104 mit einem thermisch isolierenden Material 114 ummantelt werden, sodass lediglich die Ober- und Unterseite des TEG 104 den Temperaturen T1 und T2 ausgesetzt sind.

Der TEG 104 und der oder die MEMS 102 sind auf eine Leiterplatte 108 aufgeklebt und mittels Drahtbonds und einer Umverdrahtungsebene der Leiterplatte 108 miteinander verbunden.

In einem Ausführungsbeispiel besteht die Leiterplatte 108 aus FR4-Material bzw. aus Epoxidharz, das mit 0,3 W/mK Wärmeleitfähigkeit im Vergleich zum Metalldeckel 106 ein thermischer Isolator ist. Der Metalldeckel 106 weist eine um mehrere Größenordnungen höhere (über 100 W/mK) Wärmeleitfähigkeit auf, als die Leiterplatte 108. Dies ist vorteilhaft, da somit die Leiterplatte 108 die Grenzfläche zwischen den notwendigen Temperaturen T1 und T2 darstellen kann. Des Weiteren können sich in der Leiterplatte 108 elektrische Vias befinden, die eine elektrische Verbindung zwischen der Ober- und der Unterseite der Leiterplatte 108 ermöglichen.

Der Metalldeckel 106 wird abschließend auf die Leiterplatte 108 gesetzt, um die Sensoren 102 vor Umwelteinflüssen und Beschädigungen zu schützen, und zusätzlich die Kühlfunktion zu übernehmen.

Fig. 2 zeigt eine Draufsicht auf eine elektrische Schaltung 100 ohne Deckel gemäß einem Ausführungsbeispiel der vorliegenden Erfindung. Die Schaltung 100 entspricht im Wesentlichen der Schaltung in Fig. 1. Das Bauelement 102 und der thermoelektrische Generator 104 sind in einem zentralen Bereich des Trägerelements 108 angeordnet.

In den Figuren 1 und 2 ist eine Seitenansicht und eine Ansicht von oben eines TEG 104 auf einer Leiterplatte 108 mit einer Öffnung oder Durchbohrung 110 dargestellt. In der einfachsten Bauform des hier vorgestellten Ansatzes weist die Leiterplatte 108 eine Bohrung 110 auf. MEMS 102 und TEG 104 sind auf die Leiterplatte 108 gesetzt. Der TEG 104 ist von einem thermisch isolierenden Material 114 zur seitlichen Isolation des TEG 104 umgeben. Unmittelbar unter dem TEG 104 befindet sich die Öffnung 110 in der Leiterplatte 108, über welche z. B. Luft mit der Temperatur T2 an den TEG 104 strömt. Der Deckel 106 wird über den MEMS 102 und den TEG 102 gesetzt. Dabei berührt der Deckel 106 die obere Fläche des TEG 104 mit der Temperatur T1. Als Toleranzausgleich ist eine Lage Wärmeleitpaste 112 zwischen den TEG 104 und den Deckel 106 eingebracht.

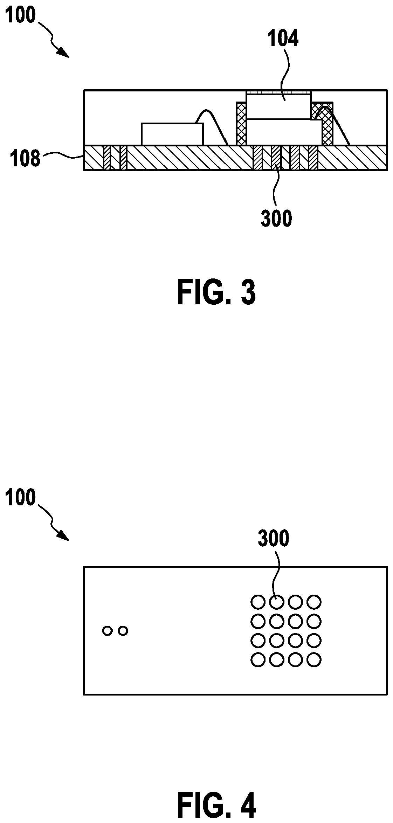

Fig. 3 zeigt eine Schnittdarstellung einer elektrischen Schaltung 100 mit thermischen Durchkontaktierungen 300 gemäß einem Ausführungsbeispiel der vorliegenden Erfindung. Die Schaltung 100 entspricht im Wesentlichen der Schaltung in Fig. 1. Zusätzlich weist das Trägerelement 108 eine Mehrzahl von wärmeleitenden Durchkontaktierungen 300 zum Leiten des Wärmestroms durch das Trägerelement 108 auf, wobei die Durchkontaktierungen 300 thermisch mit dem thermoelektrischen Generator 104 gekoppelt sind. Die Durchkontaktierungen 300 sind im Bereich einer Auflagefläche des thermoelektrischen Generators 104 auf dem Trägerelement 108 angeordnet. Die Durchkontaktierungen 300 sind als thermische Vias 300 ausgebildet. Die Durchkontaktierungen 300 sind als metallische Verbindungen von der Elementseite des Trägerelements 108 zu der Rückseite des Trägerelements 108 ausgebildet.

In einem Ausführungsbeispiel sind thermische Vias 300, also Kupferleitungen 300 zwischen Ober-und Unterseite der Leiterplatte 108, lokal unterhalb der Position des TEGs 104 in die Leiterplatte 108 integriert. Diese thermischen Vias 300 werden bereits bei der Fertigung der Leiterplatte 108 mit geringen Mehrkosten integriert. In den übrigen Eigenschaften entspricht diese Ausführungsform den zuvor beschriebenen Möglichkeiten.

Fig. 4 zeigt eine Draufsicht auf eine elektrische Schaltung 100 mit thermischen Durchkontaktierungen 300 gemäß einem Ausführungsbeispiel der vorliegenden Erfindung. Die Schaltung 100 entspricht im Wesentlichen der Schaltung in Fig. 3. Die Durchkontaktierungen 300 sind im dargestellten Ausführungsbeispiel in einem Raster aus vier Reihen und vier Zeilen von regelmäßig voneinander beabstandeten Durchkontaktierungen 300 angeordnet. Die Anzahl und Anordnung der Durchkontaktierungen 300 ist hier nur beispielhaft und kann an die Auflagefläche des thermoelektrischen Generators angepasst werden.

Neben diesen drei Hauptvarianten Leiterplatte 108 mit Bohrung 110, Bohrung 110 und Wärmeleitpaste oder thermischen Vias 300 sind auch weitere Modifikationen möglich. Für alle folgenden Ausführungsbeispiele wird exemplarisch nur die Ausführung "Leiterplatte 108 mit Bohrung 110" diskutiert. Es können jeweils auch die anderen beiden Varianten umgesetzt werden.

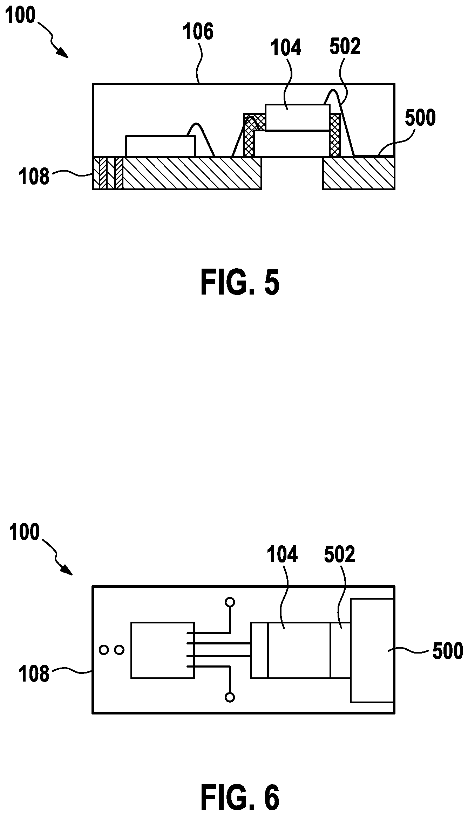

Fig. 5 zeigt eine Schnittdarstellung einer elektrischen Schaltung 100 mit einem Wärmeübertragungselement 500 gemäß einem Ausführungsbeispiel der vorliegenden Erfindung. Die Schaltung 100 entspricht im Wesentlichen der Schaltung in Fig. 1. Im Gegensatz dazu ist das Gehäuse 106 hier mit einem Abstand zu dem thermoelektrischen Generator 104 ausgebildet. Zwischen dem Gehäuse 106 und dem thermoelektrischen Generator 104 ist das Wärmeübertragungselement 500 angeordnet. Das Wärmeübertragungselement 500 ist wärmeleitend ausgebildet. Das Wärmeübertragungselement 500 ist thermisch mit dem Gehäuse 106 und dem thermoelektrischen Generator 104 gekoppelt. Durch das Wärmeübertragungselement 500 weist das Gehäuse 106 einen direkten, wärmeleitenden Kontakt zu dem thermoelektrischen Generator 104 auf. Das Wärmeübertragungselement 500 ist auf der Elementseite des Trägerelements 108 angeordnet. Das Wärmeübertragungselement 500 ist als Metallschicht 500 bzw. Metallisierungslagen 500 auf der Leiterplatte 108, insbesondere als Kupferschicht 500 auf dem Trägerelement 108 zwischen einem Rand des Trägerelements 108 und dem thermoelektrischen Generator 104 ausgebildet. Das Wärmeübertragungselement 500 ist über ein Kupferbändchen 502 mit der Kontaktfläche des thermoelektrischen Generators 104 verbunden.

In einem Ausführungsbeispiel erfolgt die Ankopplung der TEG 104 mit der Seite T1 nicht direkt an den hier metallischen Deckel 106, sondern über ein Kupferbändchen 502 und/oder Kupferschichten 500 auf der Leiterplatte 108, sodass der Deckel 106 quasi an der Unterkante kontaktiert wird. Die Kupferbändchen 502 können hierbei geklebt werden. Ein Vorteil davon ist, dass der Toleranzausgleich zwischen der Deckelhöhe und der Oberseite TEG 104 wegfällt.

Fig. 6 zeigt eine Draufsicht auf eine elektrische Schaltung 100 mit einem Wärmeübertragungselement 500 gemäß einem Ausführungsbeispiel der vorliegenden Erfindung. Die Schaltung 100 entspricht im Wesentlichen der Schaltung in Fig. 5. Das Wärmeübertragungselement 500 erstreckt sich über näherungsweise eine Breite des Trägerelements 108. Das Wärmeübertragungselement 500 ist breiter, als der thermoelektrische Generator 104. Das Kupferbändchen 502 weist die gleiche Breite auf, wie der thermoelektrische Generator 104.

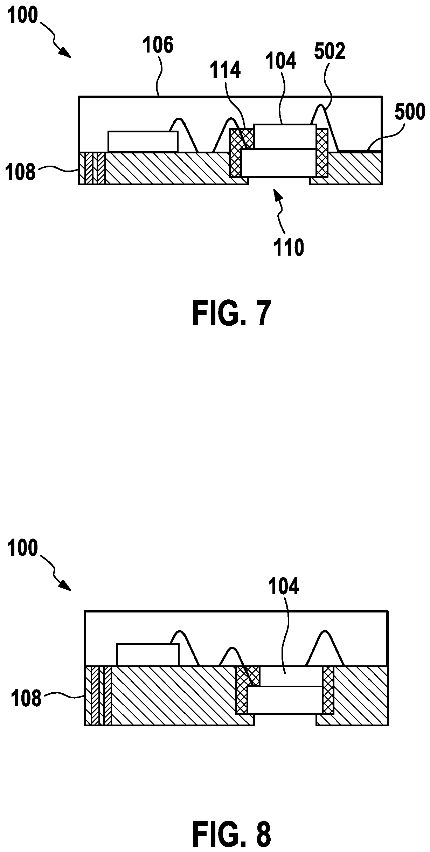

Fig. 7 zeigt eine Schnittdarstellung einer elektrischen Schaltung 100 mit teilweise versenktem thermoelektrischen Generator 104 gemäß einem Ausführungsbeispiel der vorliegenden Erfindung. Die Schaltung 100 entspricht im Wesentlichen der Schaltung in Fig. 5. Im Gegensatz dazu ist der thermoelektrische Generator 104 in das Trägerelement 108 eingelassen und das Gehäuse ist ähnlich niedrig, wie in Fig. 1. Zum Einlassen des thermoelektrischen Generators 104 weist das Trägerelement 108 eine Stufenbohrung auf, deren kleinerer Durchmesser den Durchbruch 110 repräsentiert, während der größere Durchmesser als Aufnahme für einen Teil des thermoelektrischen Generators 104 dient. Dabei ist der große Durchmesser größer, als der thermoelektrische Generator 104. Der thermoelektrische Generator 104 ist unter Verwendung des thermisch isolierenden Materials 114 in der Stufenbohrung eingegossen. Wie in Fig. 5 ist das Gehäuse 106 über das Wärmeübertragungselement 500 und das Kupferbändchen 502 mit der Kontaktfläche des thermoelektrischen Generators 104 thermisch gekoppelt.

In einem Ausführungsbeispiel ist der TEG 104 teilweise in die Leiterplatte 108 eingesetzt bzw. integriert. Hier weist die Leiterplatte 108 eine Sacklochbohrung (großer Durchmesser) gefolgt von einer Durchbohrung 110 (kleiner Durchmesser) auf. Der TEG 104 liegt auf dem entstandenen Vorsprung auf. Das Loch ist mit thermisch isolierendem (Füll-) Material 114 verfüllt. Die Kontaktierung der TEG 104 Seite T1 erfolgt wie zuvor über Kupferbändchen 502. Der TEG 104 kann ebenso direkt über den Deckel 106 kontaktiert werden.

Fig. 8 zeigt eine Schnittdarstellung einer elektrischen Schaltung 100 mit versenktem thermoelektrischen Generator 104 gemäß einem Ausführungsbeispiel der vorliegenden Erfindung. Die Schaltung 100 entspricht im Wesentlichen der Schaltung in Fig. 7. Im Gegensatz dazu ist der thermoelektrische Generator 104 vollständig in das Trägerelement 108 eingelassen. Dazu ist das Trägerelement 108 dicker, als der thermoelektrische Generator 104. Eine Tiefe des großen Durchmessers der Stufenbohrung ist an eine Höhe des thermoelektrischen Generators 104 angepasst. Die Kontaktfläche des thermoelektrischen Generators 104 schließt plan mit der Elementseite des Trägerelements 108 ab.

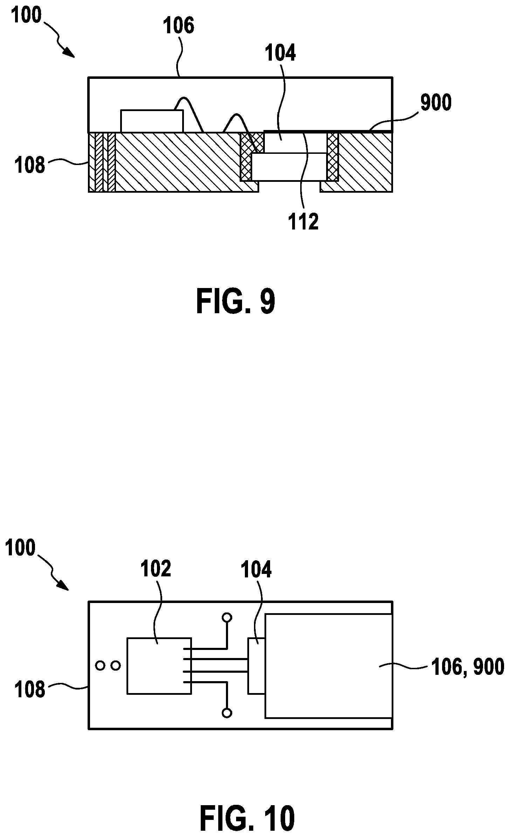

Fig. 9 zeigt eine Schnittdarstellung einer elektrischen Schaltung 100 mit erweitertem Deckel 106 gemäß einem Ausführungsbeispiel der vorliegenden Erfindung. Die Schaltung 100 entspricht im Wesentlichen der Schaltung in Fig. 8. Das Gehäuse 106 wird hier als Deckel 106 bezeichnet. Im Gegensatz zu Fig. 8 ist die Kontaktfläche des thermoelektrischen Generators 104 hier ohne das Wärmeübertragungselement mit dem Deckel 106 gekoppelt. Dazu weist der Deckel 106 einen auf dem Trägerelement 108 aufliegenden Flansch 900 auf.

In einem Ausführungsbeispiel ist zwischen der Kontaktfläche und dem Flansch Wärmeleitpaste 112 angeordnet, um den Wärmeübergang von dem Deckel 106 zu dem thermoelektrischen Generator 104 zu verbessern und möglicherweise vorhandene Toleranzen auszugleichen.

Gerade das hier gezeigte Ausführungsbeispiel bietet die Möglichkeit, dass eine alternative Deckelform als erweitertes Deckelkonzept gewählt werden kann. In Fig. 9 ist dieses Ausführungsbeispiel mit einem Deckel 106, der teilweise nach innen geklappt ist, gezeigt. Dadurch entfällt die Kontaktierung der TEG 104 Seite T1 mit Kupferbändchen und durch das Aufsetzen des Deckels 106 wird die thermische Kontaktierung sichergestellt. Wärmeleitpaste kann wieder als Toleranzausgleich dienen. Mit anderen Worten zeigt Fig. 9 einen umgeklappten Metalldeckel 106, um eine thermische Kontaktierung des TEGs 104 zu ermöglichen. Wärmeleitpaste 112 kann als Dickentoleranz verwendet werden.

Fig. 10 zeigt eine Draufsicht auf eine elektrische Schaltung 100 mit erweitertem Deckel 106 gemäß einem Ausführungsbeispiel der vorliegenden Erfindung. Die Schaltung 100 entspricht im Wesentlichen der Schaltung in Fig. 9. Der Flansch 900 des Gehäuses 106 bedeckt den thermoelektrischen Generator 104, um den elektrischen Anschluss des thermoelektrischen Generators 104 an das Bauelement 102 zu ermöglichen.

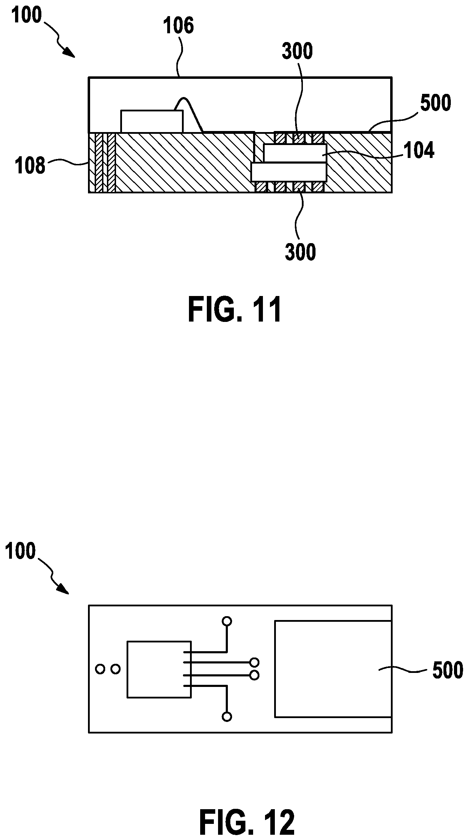

Fig. 11 zeigt eine Schnittdarstellung einer elektrischen Schaltung 100 mit eingebettetem thermoelektrischen Generator 104 gemäß einem Ausführungsbeispiel der vorliegenden Erfindung. Die Schaltung 100 entspricht im Wesentlichen der Schaltung in Fig. 9. Im Gegensatz dazu ist der thermoelektrische Generator 104 hier schon während der Herstellung des Trägerelements 108 in das Trägerelement 108 eingebettet worden. Thermisch ist der thermoelektrische Generator 104 über Durchkontaktierungen 300 zu beiden Kontaktflächen kontaktiert. Der Wärmestrom wird wie in Fig. 5 über eine Kupferschicht 500 auf dem Trägerelement 108 als Wärmeübertragungselement 500 zu dem thermoelektrischen Generator 104 geleitet. Da die Durchkontaktierungen 300 auf beiden Seiten des Trägerelements 108 flächenbündig abschließen, ist das Wärmeübertragungselement 500 direkt mit den Durchkontaktierungen verbunden.
In einem Ausführungsbeispiel ist der TEG 104 mittels der Embedding Technologie, also während des Herstellungsprozesses der Leiterplatte 108, komplett in die Leiterplatte 108 eingebracht. Die thermische Kontaktierung des TEGs 104 ist durch thermische Vias 300 sichergestellt. Die elektrische Kontaktierung durch elektrische Vias. Der Wärmestrom von der TEG 104 Seite T2 wird beispielsweise mit Kupferschichten 500 auf den Metalldeckel 106 umgeleitet.
Fig. 12 zeigt eine Draufsicht auf eine elektrische Schaltung 100 mit einem Wärmeübertragungselement 500 gemäß einem Ausführungsbeispiel der vorliegenden Erfindung. Die Schaltung 100 entspricht im Wesentlichen der Schaltung in Fig. 10. Das Wärmeübertragungselement 500 deckt die Durchkontaktierungen vollständig ab.

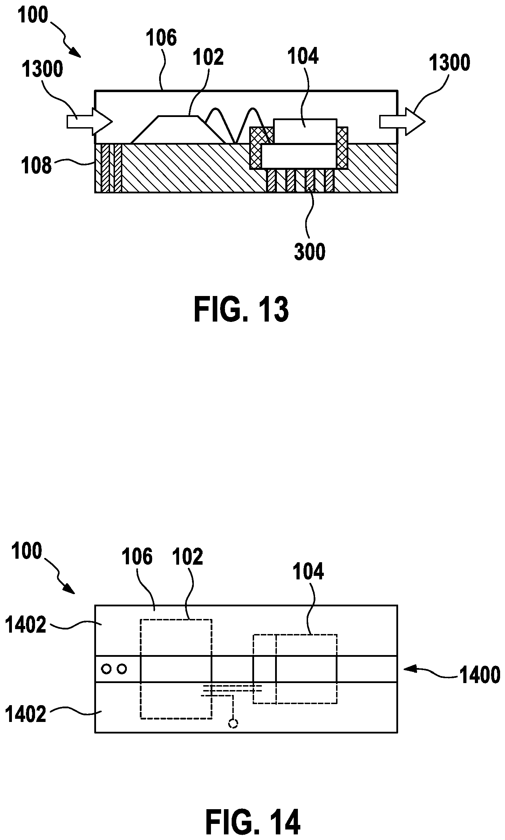

Fig. 13 zeigt eine Schnittdarstellung einer elektrischen Schaltung 100 mit einem Massenflusssensor 102 gemäß einem Ausführungsbeispiel der vorliegenden Erfindung. Die Schaltung 100 entspricht im Wesentlichen der Schaltung in Fig. 7. Im Gegensatz zu Fig. 7 ist das Bauelement 102 hier ein Massenflusssensor 102. Zusätzlich ist das Gehäuse 106 dazu ausgebildet, einen Fluidstrom 1300 eines Fluids zu dem thermoelektrischen Generator 104 zu leiten, wobei das Fluid als Trägermedium für den Wärmestrom verwendet wird. Weiterhin weist das Trägerelement 108 anstatt des Durchbruchs Durchkontaktierungen 300 zum Führen des Wärmestroms durch das Trägerelement 108 auf. Um für den Fluidstrom 1300 durchlässig zu sein, weist das Gehäuse 106 an diametral gegenüberliegenden Enden seitliche Öffnungen für den Fluidstrom 1300 auf. Wenn der Fluidstrom 1300 durch das Gehäuse 106 strömt, wird der Wärmestrom durch Konvektion zwischen der Kontaktfläche des thermoelektrischen Generators 104 und dem Fluidstrom 1300 übertragen. Das Gehäuse 106 ist hier als dünnwandiger Deckel 106 ausgeführt.

Mit anderen Worten zeigt Fig. 13 ein kompaktes Harvester-Fluidik-Package 100.

In dem hier gezeigten Ausführungsbeispiel wird der Massenfluss 1300 mit der Temperatur T1, der im Folgenden als Luftstrom 1300 bezeichnet wird, nicht nur gemessen, sondern gleichzeitig zum Wärmeaustausch an der Seite T1 des TEG 104 verwendet. Dabei wird der Fluss gemessen und nicht die Temperatur. Die andere Temperaturseite T2 des TEG 104 ist über die Leiterplatte 108 mit dem Temperaturreservoir T2 verbunden. Die dabei produzierte elektrische Energie wird direkt zum Betreiben des Massenflusssensors 102 und weiterer integrierter Bauelemente, beispielsweise Funkmodul, Temperatursensor, verwendet.

Bei dem hier vorgestellten Ansatz werden ein TEG 104, ein Massenflusssensor 102 und ggf. weitere Sensoren für Temperatur, Funkmodule, ASIC so in ein Gehäuse 100 integriert, dass der Massenfluss 1300 oder Luftstrom 1300 nicht nur durch den Massenflusssensor 102 gemessen wird, sondern gleichzeitig auch zum Wärmeaustausch an einer Seite des TEG 104 verwendet wird.

In einem Ausführungsbeispiel sind ein TEG 104 und ein Massenflusssensor 102 gemeinsam integriert. Durch Verwendung eines TEG 104 zur Energiegewinnung wird keine Batterie im Sensorelement 100 benötigt. Es wird kein zusätzlicher Kühlkörper für den TEG 104 benötigt. Dies reduziert die Baugröße erheblich und reduziert zusätzlich die Kosten. Der TEG 104 ermöglicht den autonomen Betrieb an Orten, welche beispielsweise für Vibrationsharvester ungeeignet sind. Ebenso kann das hier vorgestellte Sensorsystem ohne direkte Sonneneinstrahlung verwendet werden, welche für PV-Zellen als Energy Harvester benötigt würde. Beispielsweise ist der Betrieb am Übergang eines Lüftungsschachts einer Klimaanlage zu einem Büroraum möglich, sodass die Temperaturdifferenz zwischen gekühlter Zuluft und dem wärmeren Raumklima optimal ausgenutzt werden kann.

Fig. 14 zeigt eine Draufsicht auf eine elektrische Schaltung 100 mit einem Massenflusssensor 102 gemäß einem Ausführungsbeispiel der vorliegenden Erfindung. Die Schaltung 100 entspricht im Wesentlichen der Schaltung in Fig. 13. Zusätzlich weist das Gehäuse 106 einen Kanal 1400 zum Leiten des Fluidstroms auf. Der Kanal 1400 verläuft geradlinig von einem Ende der Schaltung 100 zum anderen Ende der Schaltung 100. Insbesondere verläuft der Kanal 1400 von einer Öffnung des Gehäuses 106 zu der anderen Öffnung des Gehäuses 106. Außerhalb des Kanals 1400 sind die Bestandteile der Schaltung 100 von einem schützenden Material 1402 bedeckt. Innerhalb des Kanals 1400 liegen sowohl eine aktive Struktur des Massenflusssensors 102, als auch die Kontaktfläche des thermoelektrischen Generators 104 frei.

Mit anderen Worten ist die Leiterplatte 108 außerhalb des Kanals 1400 mit einem Material 1402 zum Schutz vor Korrosion und zur Kanalisation bedeckt.

In einem einfachen Ausführungsbeispiel ist der Massenflusssensor 102 und der TEG 104 auf einer Leiterplatte 108 mit Standardtechniken aufgebracht und mit einem Deckel 106 aus Kunststoff und/oder Metall gehaust. Die Leiterplatte 108 kann mehrere Metallisierungsebenen umfassen. Die oberste Metallisierungsebene beinhaltet die Umverdrahtung der Sensoren 102 und des TEG 104 untereinander. Weitere Bauelemente wie Funkmodule, Temperatursensoren, ASICs sind zur besseren Übersicht nicht gezeigt, können sich aber in diesem Sensorelement 100 befinden. Die Leiterplatte 108 kann außerdem elektrische Vias zwischen den einzelnen Metallisierungsebenen umfassen. Auf der Unterseite können sich auch metallische Flächen befinden, um das Sensorsystem 100 elektrisch zu kontaktieren oder um es auf eine weitere Leiterplatte aufzulöten.

Der TEG 104 ist mit der Seite T2 an die Leiterplatte 108 mechanisch und thermisch angebunden. Dies kann beispielsweise durch thermische Vias realisiert werden.

Um den Massenfluss 1300 zu messen und einen Temperaturaustausch an der Seite T2 des TEG 104 zu ermöglichen, weist der Deckel 106 seitliche Öffnungen auf. Da durch diese Öffnungen im Deckel 106 die übrigen elektronischen Komponenten 102 (Sensoren) und die elektrischen Leiterbahnen und Bonddrähte den Umweltbedingungen ausgesetzt werden, kann eine Schutzschicht auf die empfindlichen Bauteile und Leiterbahnen/Drahtbonds aufgebracht werden.

Durch die Schutzschicht kann beispielsweise Korrosion verhindert werden. Damit kann die Zuverlässigkeit des Moduls 100 verbessert werden. Die Schutzschicht kann beispielsweise durch Dispensen eines geeigneten Passivierungspolymers aufgebaut werden. Zusätzlich kann dieses Polymer zur Kanalisation des Massenstroms durch das Bauelement 100 verwendet werden.

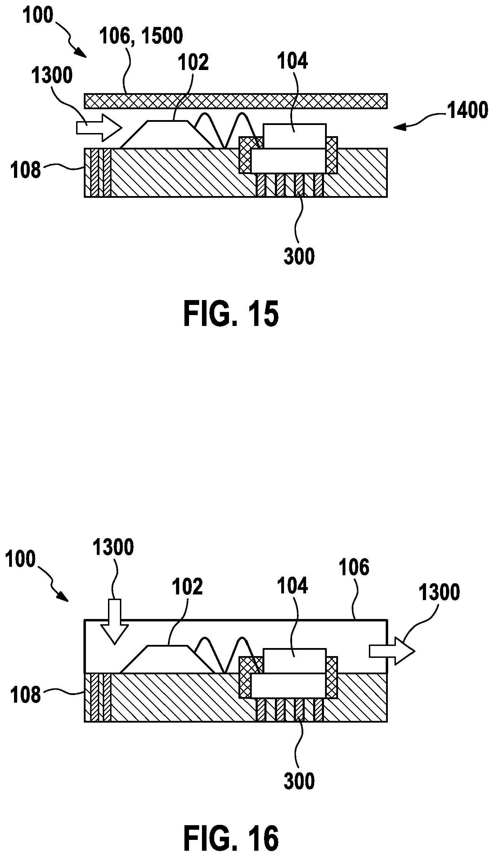

Fig. 15 zeigt eine Schnittdarstellung einer elektrischen Schaltung 100 mit einem Gehäuse 106 mit Kanal 1400 gemäß einem Ausführungsbeispiel der vorliegenden Erfindung. Die Schaltung 100 entspricht im Wesentlichen der Schaltung in Fig. 13. Im Gegensatz dazu ist das Gehäuse 106 mit Ausnahme des Kanals 1400 massiv aus einem Gehäusematerial 1500 ausgeführt.

In einem Ausführungsbeispiel ist der Kanal 1400 zum Leiten des Fluidstroms 1300 unter Verwendung eines entfernbaren Materials hergestellt worden. Das entfernbare Material ist dabei als Platzhalter für den Kanal 1400 eingesetzt worden. Beim Aufbringen des Gehäusematerials 1500 hat das Gehäusematerial 1500 den Platzhalter umflossen und ist ausgehärtet. Dann ist das entfernbare Material entfernt worden, um den Kanal 1400 durch das Gehäusematerial 1500 zu bilden.

In einem Ausführungsbeispiel ist der Kanal 1400 zum Leiten des Fluidstroms 1300 unter Verwendung eines vorgefertigten Gehäuses 106 hergestellt worden. Dazu ist das Gehäusematerial 1500 in eine Form gegossen worden, in der Form ausgehärtet und in ausgehärtetem Zustand aus der Form entnommen worden. Die Form bildet dabei einen Negativabdruck des Gehäuses 106 und des Kanals 1400 ab. Das fertige Gehäuse 106 ist unter Verwendung einer Klebeschicht auf das Trägerelement 108 mit dem Bauelement 102 und dem thermoelektrischen Generator 104 aufgesetzt worden.

Wie in Fig. 14 liegen innerhalb des Kanals 1400 aktive Flächen des Bauelements 102 und des thermoelektrischen Generators 104 frei.

In einem Ausführungsbeispiel ist der Aufbau, wie er in Fig. 13 gezeigt ist, mit Kanälen in Moldmasse 1500 statt durch einen Deckel ausgeführt. Moldmasse 1500 ist ein Duroplast und kann verwendet werden, um Sensoren 102 permanent vor Umwelteinflüssen zu schützen. Hierfür wird das gesamte System 100 beim Moldvorgang überspritzt und es werden alle Bereiche permanent überdeckt. Mit thermisch zersetzbaren Polymeren als Opferschicht kann ein Kanal 1400 in der Moldmasse 1500 realisiert werden. Hierfür wird der Bereich des späteren Kanals 1400 vor dem Molden mit dem zersetzbaren Polymer bedeckt bzw. strukturiert. Anschließend wird das Sensorsystem 100 mit dem Duroplast 1500 überspritzt. Wird das System 100 nun auf eine bestimmte Temperatur erhitzt, so zersetzt sich das Polymer rückstandslos und es entsteht ein Kanal 1400 in der Moldmasse 1500.

Fig. 16 zeigt eine Schnittdarstellung einer elektrischen Schaltung 100 mit abgewinkeltem Massenfluss 1300 gemäß einem Ausführungsbeispiel der vorliegenden Erfindung. Die Schaltung 100 entspricht im Wesentlichen der Schaltung in Fig. 13. Im Gegensatz dazu ist die Öffnung im Gehäuse 106, durch die der Fluidstrom 1300 einströmen oder ausströmen kann, auf der, von dem Trägerelement 108 abgewandten Seite des Gehäuses 106 angeordnet. Dadurch wird der Fluidstrom 1300 im Gehäuse rechtwinklig umgelenkt und strömt im Gehäuse 106 im Wesentlichen entlang des Trägerelements 108 und damit über den thermoelektrischen Generator 104 und den Massenflusssensor 102 hinweg.

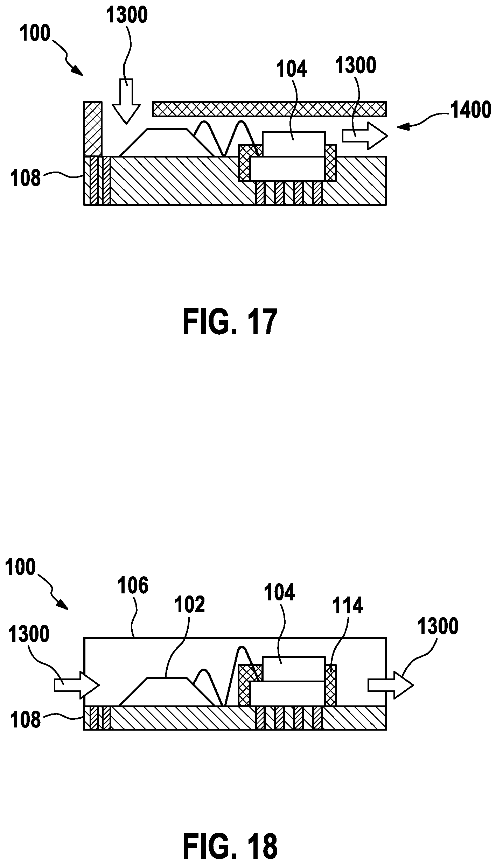

Fig. 17 zeigt eine Schnittdarstellung einer elektrischen Schaltung 100 mit einem Gehäuse 106 mit Kanal 1400 und abgewinkeltem Massenfluss 1300 gemäß einem Ausführungsbeispiel der vorliegenden Erfindung. Die Schaltung 100 entspricht im Wesentlichen der Schaltung in Fig. 16. Im Gegensatz dazu ist das Gehäuse 106 wie in Fig. 15 aus dem Gehäusematerial 1500 und weist den Kanal 1400 mit abgewinkeltem Massenfluss 1300, wie in Fig. 16 auf.

Der Luftstrom 1300 durch das Sensorelement 100 kann je nach Anforderung anders ausgerichtet sein. Beispielsweise kann der Deckel 106 eine Öffnung an der Oberseite haben und auch die Kanäle 1400 in der Moldmasse 1500 können anders als lateral verlaufen. Beispielsweise können die Kanäle 1400 vertikal ausgerichtet sein, sodass eine Öffnung an der Oberseite möglich wird.

In einem Ausführungsbeispiel wird anstelle von Molden und Opferschicht ein durch Spritzgießen vorgefertigter Kunststoffdeckel (Premold) verwendet, um den Kanal 1400 bzw. die Kanalisation in der Moldmasse 1500 zu gewährleisten. Außer einer zusätzlich nötigen Kleberschicht zum Aufkleben des Premold Deckels unterscheidet sich die Bauform nicht von vorher beschriebenen Ausführungsbeispielen.

Fig. 18 zeigt eine Schnittdarstellung einer elektrischen Schaltung mit aufgesetztem thermoelektrischen Generator gemäß einem Ausführungsbeispiel der vorliegenden Erfindung. Die Schaltung 100 entspricht im Wesentlichen der Schaltung in Fig. 13. Wie in Fig. 13 ist das Bauelement 102 als Massenflusssensor 102 ausgebildet und dazu ausgebildet, den Massenstrom 1300 durch das Gehäuse 106 zu erfassen. Im Gegensatz dazu ist der thermoelektrische Generator 104 wie in Fig. 3 auf dem Trägerelement 108 aufliegend angeordnet. Der thermoelektrische Generator 104 ist zum Vermeiden eines thermischen Kurzschlusses durch das Isoliermaterial 114 isoliert.

In den bisherigen gezeigten Ausführungsbeispielen wurde der TEG 104 etwas in die Leiterplatte 108 versenkt, sodass der Luftstrom 1300 durch das Package 100 nicht an dem überstehenden TEG 104 verwirbelt wird.

In einem weiteren Ausführungsbeispiel ist der TEG 104 auf die Leiterplatte 108 angeordnet. Die Luftverwirbelungen beeinflussen die Funktionsweise des Sensorelements 102 nicht signifikant. In diesem Fall ist der TEG 104 an den Seitenwänden mit einem Isolationsstoff 114 thermisch isoliert, da sich sonst ein thermischer Kurzschluss zwischen den beiden Temperaturseiten T1 und T2 ergeben könnte.

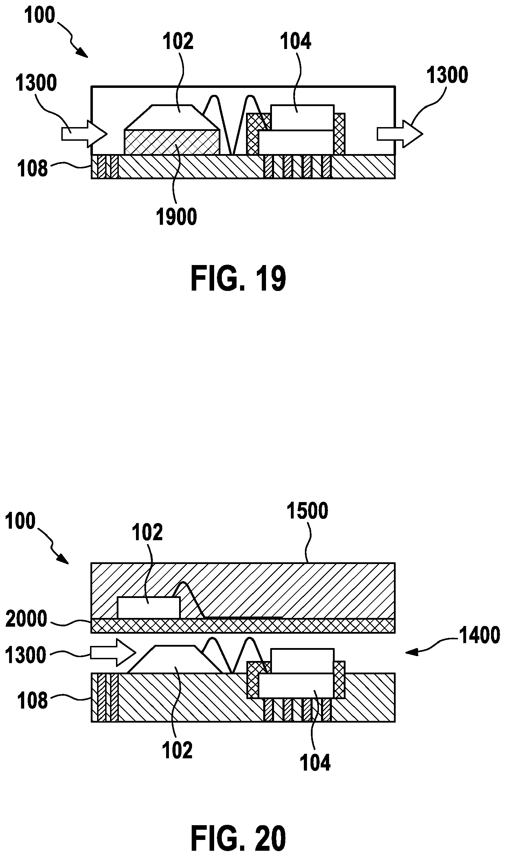

Fig. 19 zeigt eine Schnittdarstellung einer elektrischen Schaltung 100 mit einem erhöhten Massenflusssensor 102 gemäß einem Ausführungsbeispiel der vorliegenden Erfindung. Die Schaltung 100 entspricht im Wesentlichen der Schaltung in Fig. 18. Zusätzlich ist zwischen dem Bauelement 102 und dem Trägerelement 108 eine Zwischenschicht 1900 angeordnet. Die Zwischenschicht 1900 beabstandet das Bauelement 102 von dem Trägerelement 108, sodass es in einem Bereich des Fluidstroms 1300 angeordnet ist, in dem reduzierte Störungen der Strömung durch den thermoelektrischen Generator 104 zu erwarten sind. Dadurch kann der Massenflusssensor 102 besonders gut arbeiten.

In einem Ausführungsbeispiel ist die Höhe des Massenflusssensors 102 mit Abstandhaltern 1900 aus Kunststoff oder Metall an die Höhe des TEG 104 angepasst, um den Luftstrom durch das Sensorelement 100 zu optimieren. Dadurch wird eine Anpassung der relativen Höhe des Massenflusssensors 102 und des TEG 104 zueinander erreicht. Der Abstandshalter 1900 kann beispielsweise als Kunststoffplättchen oder Metallplättchen ausgeführt werden.

Fig. 20 zeigt eine Schnittdarstellung einer elektrischen Schaltung 100 mit mehreren Bauelementen 102 gemäß einem Ausführungsbeispiel der vorliegenden Erfindung. Die Schaltung 100 entspricht im Wesentlichen der Schaltung in Fig. 15. Im Gegensatz dazu ist der Kanal 1400 zwischen dem Trägerelement 108 und einem weiteren Trägerelement 2000 ausgebildet. Die Trägerelemente 108, 2000 sind beabstandet voneinander angeordnet. Der Abstand der Trägerelemente 108, 2000 entspricht dabei einer Höhe des Kanals 1400. Außerhalb des Kanals 1400 sind die Trägerelemente 108, 2000 über Abstandhalter miteinander verbunden. Das erste Bauelement 102 ist als Massenflusssensor 102 ausgebildet und ist innerhalb des Kanals 1400 für den Fluidstrom 1300 angeordnet. Das zumindest eine weitere Bauelement 102 ist elektrisch mit dem thermoelektrischen Generator 104 verbunden. Das weitere Bauelement 102 ist dazu ausgebildet, von dem thermoelektrischen Generator 104 mit elektrischer Energie versorgt zu werden. Das weitere Bauelement 102 ist auf einer, dem Kanal 1400 gegenüberliegenden Seite des weiteren Trägerelements 2000 angeordnet. Das weitere Bauelement 102 ist von Gehäusematerial 1500 umgossen. Die Schaltung 100 weist Leiterbahnen zur Verbindung des oberen und unteren Moduls 102 auf.

In einem Ausführungsbeispiel ist das weitere Bauelement 102 ein weiterer Sensor 102 zum Erfassen einer weiteren Messgröße.

In einem Ausführungsbeispiel ist das weitere Bauelement 102 ein integrierter Schaltkreis 102 zum Verarbeiten von Sensorsignalen des ersten Sensors 102.

In einem Ausführungsbeispiel weist das Gehäuse 106 eine erste, direkt auf dem Trägerelement 108 angeordnete erste Schicht und zumindest eine auf der ersten Schicht angeordneten zweite Schicht auf. Die erste Schicht weist den Kanal 1400 zum Leiten des Fluidstroms 1300 auf.

In einem Ausführungsbeispiel ist der Kanal 1400 durch das Stacking von mehreren Leiterplatten 108, 2000 gebildet. Beispielsweise ist in Fig. 20 ein Package-on-Package (PoP) 100 gezeigt. Beim Verpacken durch PoP werden zwei oder mehrere Packages übereinander gesetzt und mit Lötballs elektrisch und mechanisch verbunden. Bei diesem Verfahren ist es sehr leicht möglich, beispielsweise an gegenüberliegenden Seiten einige Lötballs auszusparen und die restlichen Lötballs mit einem Underfiller als Dichtmaterial oder einem zusätzlichen Versiegelungsring aus Lotpaste zu verschließen. Auf diese Weise wird ein Luftkanal 1400 zwischen zwei Packages 108, 2000 hergestellt. Optional können kritische Strukturen auf der Leiterplatte 108 des TEGs 104 und/oder des Massenflusssensors 102 mit einer Schutzschicht überzogen werden.

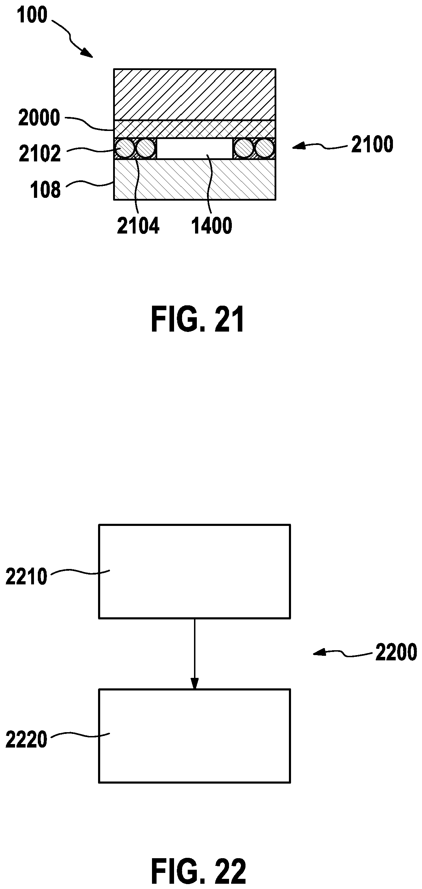

Fig. 21 zeigt eine Schnittdarstellung einer elektrischen Schaltung 100 mit einem Kanal 1400 zwischen gestapelten Leiterplatten 108, 2000 gemäß einem Ausführungsbeispiel der vorliegenden Erfindung. Es ist ein Ausschnitt der in Fig. 20 dargestellten Schaltung dargestellt. Hier ist der Kanal 1400 entlang seiner Längsachse gezeigt. Die Abstandhalter 2100 weisen metallische Stützelemente 2102 und eine Füllmasse 2104 auf. Die Stützelemente 2102 definieren den Abstand der Leiterplatten 108, 2000. Die Füllmasse 2104 dichtet Lücken zwischen den Stützelementen 2102 ab.

Fig. 22 zeigt ein Ablaufdiagramm eines Verfahrens 2200 zur Herstellung einer elektrischen Schaltung gemäß einem Ausführungsbeispiel der vorliegenden Erfindung. Das Verfahren 2200 umfasst einen Schritt des Bereitstellens 2210 eines Bauelements, insbesondere eines Sensorelements zum Erfassen einer Messgröße, eines thermoelektrischen Generators, der elektrisch mit dem Bauelement verbunden ist und ebenfalls mit dem Trägerelement mechanisch verbunden ist, wobei der thermoelektrische Generator dazu ausgebildet ist, das Bauelement unter Verwendung eines, den thermoelektrischen Generator durchströmenden Wärmestroms mit elektrischer Energie zu versorgen und eines Gehäuses, wobei das Gehäuse dazu ausgebildet ist, den Wärmestrom zu dem thermoelektrischen Generator zu leiten. Ferner umfasst das Verfahren 2200 einen Schritt 2220 des Anordnens des Gehäuses auf der Elementseite des Trägerelements, derart, dass es das Bauelement sowie den thermoelektrischen Generator zumindest teilweise bedeckt.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können erfindungsgemäße Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Elektrische Schaltung (100) mit folgenden Merkmalen:
Mindestens einem Bauelement (102), insbesondere einem Sensorelement (102) zum Erfassen einer Messgröße, wobei das Bauelement (102) mit einer Elementseite eines Trägerelements (108) der Schaltung (100) mechanisch verbunden ist;
einem thermoelektrischen Generator (104), der elektrisch mit dem Bauelement (102) verbunden ist und ebenfalls mit dem Trägerelement (108) mechanisch verbunden ist, wobei der thermoelektrische Generator (104) dazu ausgebildet ist, das Bauelement (102) unter Verwendung eines, den thermoelektrischen Generator (104) durchströmenden Wärmestroms mit elektrischer Energie zu versorgen; und
einem Gehäuse (106), das auf der Elementseite des Trägerelements (108) angeordnet ist und das Bauelement (102) sowie den thermoelektrischen Generator (104) zumindest teilweise bedeckt, wobei das Gehäuse (106) dazu ausgebildet ist, den Wärmestrom zu dem thermoelektrischen Generator (104) zu leiten,
**dadurch gekennzeichnet, dass**
das Gehäuse (106) dazu ausgebildet ist, einen Fluidstrom (1300) eines Fluids zu dem thermoelektrischen Generator (104) zu leiten, wobei das Fluid als Trägermedium für den Wärmestrom verwendet wird oder verwendbar ist.

2. Elektrische Schaltung (100) gemäß Anspruch 1, bei der das Gehäuse (106) eine erste, direkt auf dem Trägerelement (108) angeordnete erste Schicht und zumindest eine auf der ersten Schicht angeordneten zweite Schicht aufweist, wobei die erste Schicht einen Kanal (1400) zum Leiten des Fluidstroms (1300) aufweist.

3. Elektrische Schaltung (100) gemäß einem der vorangegangenen Ansprüche, bei der das Bauelement (102) ein Massenflusssensor (102) ist.

4. Elektrische Schaltung (100) gemäß einem der vorangegangenen Ansprüche, bei der das Gehäuse (106) ein wärmeleitendes Material aufweist thermisch mit dem thermoelektrischen Generator (104) gekoppelt ist.

5. Elektrische Schaltung (100) gemäß einem der vorangegangenen Ansprüche, bei der zwischen dem Gehäuse (106) und dem thermoelektrischen Generator (104) ein wärmeleitendes Wärmeübertragungselement (500) angeordnet ist, das mit dem Gehäuse (106) und dem thermoelektrischen Generator (104) thermisch gekoppelt ist.

6. Elektrische Schaltung (100) gemäß einem der vorangegangenen Ansprüche, bei der der thermoelektrische Generator (104) zumindest teilweise in dem Trägerelement (108) versenkt angeordnet ist.

7. Elektrische Schaltung (100) gemäß einem der vorangegangenen Ansprüche, bei der zwischen dem Bauelement (102) und dem Trägerelement (108) eine Zwischenschicht (1900) angeordnet ist.

8. Elektrische Schaltung (100) gemäß einem der vorangegangenen Ansprüche, bei der das Trägerelement (108) zumindest eine wärmeleitende Durchkontaktierung (300) zum Leiten des Wärmestroms durch das Trägerelement (108) aufweist, wobei die Durchkontaktierung (300) mit dem thermoelektrischen Generator (104) thermisch gekoppelt ist.

9. Elektrische Schaltung (100) gemäß einem der vorangegangenen Ansprüche, bei der das Trägerelement (108) zumindest einen Durchbruch (110) zum Leiten des Wärmestroms durch das Trägerelement (108) aufweist, wobei der Durchbruch (110) im Bereich einer Kontaktfläche zwischen dem thermoelektrischen Generator (104) und dem Trägerelement (108) angeordnet ist.

10. Elektrische Schaltung (100) gemäß einem der vorangegangenen Ansprüche, mit zumindest einem weiteren Bauelement (102), das elektrisch mit dem thermoelektrischen Generator (104) verbunden ist, wobei das weitere Bauelement (102) dazu ausgebildet ist, von dem thermoelektrischen Generator (104) mit elektrischer Energie versorgt zu werden.

11. Verfahren (2200) zur Herstellung einer elektrischen Schaltung, wobei das Verfahren (2200) die folgenden Schritte aufweist:
- Bereitstellen (2210) eines Bauelements (102), insbesondere eines Sensorelements (102) zum Erfassen einer Messgröße, eines thermoelektrischen Generators (104), der elektrisch mit dem Bauelement (102) verbunden ist und ebenfalls mit dem Trägerelement (108) mechanisch verbunden ist, wobei der thermoelektrische Generator (104) dazu ausgebildet ist, das Bauelement (102) unter Verwendung eines, den thermoelektrischen Generator (104) durchströmenden Wärmestroms mit elektrischer Energie zu versorgen und eines Gehäuses (106), wobei das Gehäuse (106) dazu ausgebildet ist, den Wärmestrom zu dem thermoelektrischen Generator (104) zu leiten; und
- Anordnen (2220) des Gehäuses auf der Elementseite des Trägerelements (108), derart, dass es das Bauelement (102) sowie den thermoelektrischen Generator (104) zumindest teilweise bedeckt,
**dadurch gekennzeichnet, dass**
der Schritt des Anordnens (2220) derart erfolgt, dass das Gehäuse (106) dazu ausgebildet wird, einen Fluidstrom (1300) eines Fluids zu dem thermoelektrischen Generator (104) zu leiten, wobei das Fluid als Trägermedium für den Wärmestrom verwendet wird oder verwendbar ist.

## Claims

1. Electrical circuit (100) having the following features:
at least one component (102), in particular a sensor element (102) for sensing a quantity to be measured, wherein the component (102) is mechanically connected to an element side of a carrier element (108) of the circuit (100);
a thermoelectric generator (104), which is electrically connected to the component (102) and is also mechanically connected to the carrier element (108), wherein the thermoelectric generator (104) is designed to supply the component (102) with electrical energy with use of a heat flow flowing through the thermoelectric generator (104); and
a housing (106), which is arranged on the element side of the carrier element (108) and at least partially covers the component (102) and the thermoelectric generator (104), wherein the housing (106) is designed to conduct the heat flow to the thermoelectric generator (104),
**characterized in that**
the housing (106) is designed to conduct a fluid flow (1300) of a fluid to the thermoelectric generator (104), wherein the fluid is used or can be used as carrier medium for the heat flow.

2. Electrical circuit (100) according to Claim 1, wherein the housing (106) has a first layer arranged directly on the carrier element (108) and at least one second layer arranged on the first layer, wherein the first layer has a duct (1400) for conducting the fluid flow (1300).

3. Electrical circuit (100) according to one of the preceding claims, wherein the component (102) is a mass flow sensor (102).

4. Electrical circuit (100) according to one of the preceding claims, wherein the housing (106) comprises a heat-conducting material and is thermally coupled to the thermoelectric generator (104).

5. Electrical circuit (100) according to one of the preceding claims, wherein a heat-conducting heat-transfer element (500) is arranged between the housing (106) and the thermoelectric generator (104), which element is thermally coupled to the housing (106) and the thermoelectric generator (104).

6. Electrical circuit (100) according to one of the preceding claims, wherein the thermoelectric generator (104) is at least partially recessed in the carrier element (108).

7. Electrical circuit (100) according to one of the preceding claims, wherein an intermediate layer (1900) is arranged between the component (102) and the carrier element (108).

8. Electrical circuit (100) according to one of the preceding claims, wherein the carrier element (108) has at least one heat-conducting feedthrough (300) for conducting the heat flow through the carrier element (108), wherein the feedthrough (300) is thermally coupled to the thermoelectric generator (104).

9. Electrical circuit (100) according to one of the preceding claims, wherein the carrier element (108) has at least one aperture (110) for conducting the heat flow through the carrier element (108), wherein the aperture (110) is arranged in the region of a contact surface between the thermoelectric generator (104) and the carrier element (108).

10. Electrical circuit (100) according to one of the preceding claims, having at least one further component (102), which is electrically connected to the thermoelectric generator (104), wherein the further component (102) is designed to be supplied with electrical energy by the thermoelectric generator (104).

11. Method (2200) for producing an electrical circuit, wherein the method (2200) comprises the following steps:
- providing (2210) a component (102), in particular a sensor element (102) for sensing a quantity to be measured, a thermoelectric generator (104), which is electrically connected to the component (102) and is also mechanically connected to the carrier element (108), wherein the thermoelectric generator (104) is designed to supply the component (102) with electrical energy with use of a heat flow flowing through the thermoelectric generator (104), and a housing (106), wherein the housing (106) is designed to conduct the heat flow to the thermoelectric generator (104); and
- arranging (2220) the housing on the element side of the carrier element (108), in such a way that it at least partially covers the component (102) and the thermoelectric generator (104),
**characterized in that**
the arranging step (2220) is carried out in such a way that the housing (106) is designed to conduct a fluid flow (1300) of a fluid to the thermoelectric generator (104), wherein the fluid is used or can be used as carrier medium for the heat flow.

## Revendications

1. Circuit électrique (100) présentant les caractéristiques suivantes :
au moins un composant (102), en particulier un élément capteur (102), destiné à détecter une grandeur de mesure, dans lequel le composant (102) est relié mécaniquement à un côté élément d'un élément de support (103) du circuit (100) ;
un générateur thermoélectrique (104) qui est relié électriquement au composant (102) et qui est également relié mécaniquement à l'élément de support (103), dans lequel le générateur thermoélectrique (104) est conçu pour alimenter le composant (102) en énergie électrique par utilisation d'un flux de chaleur circulant à travers le générateur thermoélectrique (104) ; et
un boîtier (106) qui est disposé sur le côté élément de l'élément de support (108) et recouvre au moins partiellement le composant (102) et le générateur thermoélectrique (104), dans lequel le boîtier (106) est configuré pour conduire le courant de chaleur vers le générateur thermoélectrique (104),
**caractérisé en ce que**
le boîtier (106) est configuré pour acheminer un courant de fluide (1300) d'un fluide vers le générateur thermoélectrique (104), dans lequel le fluide est utilisé ou peut être utilisé en tant que milieu de support pour le courant de chaleur.

2. Circuit électrique (100) selon la revendication 1, dans lequel le boîtier (106) comporte une première couche directement disposée sur l'élément de support (108) et au moins une seconde couche disposée sur la première couche, dans lequel la première couche comporte un canal (1400) destiné à acheminer le courant de fluide (1300).

3. Circuit électrique (100) selon l'une quelconque des revendications précédentes, dans lequel le composant (102) est un capteur de débit massique (102).

4. Circuit électrique (100) selon l'une quelconque des revendications précédentes, dans lequel le boîtier (106) comporte un matériau thermiquement conducteur couplé thermiquement au générateur thermoélectrique (104).

5. Circuit électrique (100) selon l'une quelconque des revendications précédentes, dans lequel un élément de transmission de chaleur (500) thermiquement conducteur, qui est thermiquement couplé au boîter (106) et au générateur thermoélectrique (104), est disposé entre le boîtier (106) et le générateur thermoélectrique (104).

6. Circuit électrique (100) selon l'une quelconque des revendications précédentes, dans lequel le générateur thermoélectrique (104) est disposé de manière au moins partiellement encastrée dans l'élément de support (108).

7. Circuit électrique (100) selon l'une quelconque des revendications précédentes, dans lequel une couche intermédiaire (1900) est disposée entre le composant (102) et l'élément de support (108).

8. Circuit électrique (100) selon l'une quelconque des revendications précédentes, dans lequel l'élément de support (108) comporte au moins un contact traversant thermiquement conducteur (300) destiné à acheminer le courant de chaleur à travers l'élément de support (108), dans lequel le contact traversant (300) est couplé thermiquement au générateur thermoélectrique (104).

9. Circuit électrique (100) selon l'une quelconque des revendications précédentes, dans lequel l'élément de support (108) comporte au moins une traversée (110) destinée à acheminer le courant de chaleur à travers l'élément de support (108), dans lequel la traversée (110) est disposée dans la région d'une surface de contact entre le générateur thermoélectrique (104) et l'élément de support (108).

10. Circuit électrique (100) selon l'une quelconque des revendications précédentes, comportant au moins un autre composant (102) électriquement relié au générateur thermoélectrique (104), dans lequel l'autre composant (102) est configuré pour être alimenté en énergie électrique par le générateur thermoélectrique (104).

11. Procédé (2200) de production d'un circuit électrique, dans lequel le procédé (2200) comprend les étapes consistant à :
- fournir (2210) un composant (102), en particulier un élément capteur (102) destiné à détecter une grandeur de mesure, un générateur thermoélectrique (104) qui est relié électriquement au composant (102) et est également relié mécaniquement à l'élément de support (108), dans lequel le générateur thermoélectrique (104) est configuré pour alimenter en énergie électrique le composant (102) par utilisation d'un courant de chaleur circulant à travers le générateur thermoélectrique (104), et un boîtier (106), dans lequel le boîtier (106) est configuré pour acheminer le courant de chaleur vers le générateur thermoélectrique (104) ; et
- mettre en place (2220) le boîtier sur le côté élément de l'élément de support (108) de manière à ce qu'il recouvre au moins partiellement le composant (102) et le générateur thermoélectrique (104),
**caractérisé en ce que**
l'étape de mise en place (2220) est effectuée de manière à ce que le boîtier (106) soit configuré pour acheminer un courant de fluide (1300) d'un fluide vers le générateur thermoélectrique (104), dans lequel le fluide est utilisé ou peut être utilisé en tant que milieu de support pour le courant de chaleur.
